# EUROPÄISCHE PATENTSCHRIFT

(11) **EP 2 232 526 B1**
(45) Veröffentlichungstag und Bekanntmachung des Hinweises auf die Patenterteilung: **04.05.2011**
(21) Anmeldenummer: 08861689.1
(22) Anmeldetag: 18.12.2008
(51) Int. Cl.: H01L 21/00, B05C 1/02, B05C 1/08

(54) **VERFAHREN UND VORRICHTUNG ZUR BEHANDLUNG VON SILIZIUM-WAFERN**
METHOD AND DEVICE FOR TREATING SILICON WAFERS
PROCÉDÉ ET DISPOSITIF DE TRAITEMENT DE TRANCHES DE SILICIUM

(30) Priorität: 19.12.2007 DE 102007063202
(43) Veröffentlichungstag der Anmeldung: 29.09.2010
(73) Patentinhaber: Gebr. Schmid GmbH & Co., 72250 Freudenstadt (DE)
(72) Erfinder: KAPPLER, Heinz, 72280 Dornstetten-Aach (DE)
(74) Vertreter: Patentanwälte Ruff, Wilhelm, Beier, Dauster & Partner
(86) Internationale Anmeldenummer: PCT/EP2008/010894
(87) Internationale Veröffentlichungsnummer: WO 2009/077201

(56) Entgegenhaltungen:
- WO-A-2005/013342
- WO-A-2007/073886
- US-A1- 2006 154 490
- US-A1- 2007 246 085

## Beschreibung

Die Erfindung betrifft ein Verfahren zur Behandlung von Silizium-Wafern, insbesondere zum Texturieren und Polierätzen mit Ätzlösung.

Bisher ist es bekannt, von Silizium-Wafern mit Ätzlösung von beiden Seiten der Silizium-Wafer ca. 5µm abzuätzen. Damit können zum einen Sägeschäden beseitigt werden. Des weiteren kann eine texturierte Oberseite geschaffen werden, welche für die Leistungsfähigkeit der aus dem Silizium-Wafer hergestellten Solarzelle bedeutsam ist. Des weiteren sollte die Unterseite möglichst glatt bzw. glänzend sein, damit hindurchgegangenes Licht reflektiert wird und seine Energie beim Rückweg genutzt werden kann.

Die WO 2005/013342 A beschreibt ein Verfahren und eine Vorrichtung, um eine Resist-Schicht von der Oberseite eines Substrats zu entfernen. Dabei befinden sich oberhalb einer horizontalen Transportbahn Düsenrohre. Diese bringen von oben Behandlungsflüssigkeit auf, wobei der Aufbringungswinkel eingestellt werden kann.

Die US 2006/154490 A1 beschreibt ein Verfahren und eine Vorrichtung, um auf die Oberseite von Substraten auf einer horizontalen Transportbahn Ätzlösung aufzubringen.

Die US 2007/246085 A1 beschreibt nochmals ein weiteres Verfahren und eine Vorrichtung, um eine Resist-Schicht von der Oberseite eines Substrates zu entfernen. Dabei wird das Substrat auf einer horizontalen Transportbahn transportiert und von oben wird schräg entgegen die Transportrichtung des Substrats Behandlungsflüssigkeit ausgebracht. Dabei wird gleichzeitig von unten über weitere Düsen heißes Wasser auf Transportrollen aufgebracht, die die Transportbahn für die Substrate bilden.

### Aufgabe und Lösung

Der Erfindung liegt die Aufgabe zugrunde, ein eingangs genanntes Verfahren zu schaffen, mit dem Probleme des Standes der Technik gelöst werden können und insbesondere eine vorteilhafte Weiterentwicklung möglich ist sowie ein verbessertes und effizientes Ätzen der Silizium-Wafer.

Gelöst wird diese Aufgabe durch ein Verfahren mit den Merkmalen des Anspruchs 1. Vorteilhafte sowie bevorzugte Ausgestaltungen der Erfindung sind Gegenstand der weiteren Ansprüche und werden im Folgenden näher erläutert. Der Wortlaut der Ansprüche wird durch ausdrückliche Bezugnahme zum Inhalt der Beschreibung gemacht.

Erfindungsgemäß ist vorgesehen, dass in einem ersten Verfahrensschritt die Silizium-Wafer liegend transportiert werden, und zwar entlang einer horizontalen Transportbahn. Von oben wird Ätzlösung zum Texturieren aufgebracht bzw. aufgesprüht, wozu Düsen, Schwallrohre odgl. verwendet werden können, welche an sich zu einem derartigen Zweck bekannt sind. Von unterhalb der Silizium-Wafer erfolgt in diesem Verfahrensschritt entweder gar kein Aufbringen von Flüssigkeit auf die Silizium-Wafer bzw. deren Unterseite oder nur in geringem Maß. Auf alle Fälle wird von der Unterseite her keine Ätzflüssigkeit aufgesprüht odgl.. Dazu kann eine entsprechend geeignet ausgebildete Vorrichtung oberhalb der Transportbahn die genannten Düsen oder Schwallrohre odgl. aufweisen zum Benetzen der Oberseite. Unter der Unterseite sind derartige Düsen odgl. gar nicht vorgesehen.

In einem späteren bzw. zweiten Verfahrensschritt werden die Silizium-Wafer gleich bzw. mit gleicher Ausrichtung wie im ersten Verfahrensschritt auf der Transportbahn liegend von unten mit Ätzlösung benetzt zum Polierätzen. Vorteilhaft erfolgt hier ein Aufbringen der Ätzlösung tatsächlich ausschließlich von unten und auch ausschließlich auf die Unterseite. Gerade wenn nämlich Transportrollen odgl. für die Transportbahn verwendet werden, kann im ersten Verfahrensschritt etwas Ätzlösung von oben auch auf diese Transportrollen gelangen und dann von den Transportrollen an die Unterseite der Silizium-Wafer übertragen werden. Da dies aber eine überschaubare Menge ist, kann hier die Ätzwirkung sehr gering bleiben. Sie kann sogar vorteilhaft sein, beispielsweise in Vorbereitung des zweiten Verfahrensschrittes.

Auf diese Art und Weise kann in einem ersten Verfahrensschritt zum Beseitigen der Sägeschäden und zum Texturieren der Oberseite etwa 4µm bis 6µm Material abgetragen werden, vorzugsweise ca. 5µm. Die Verfahrensdauer kann hier etwa 80 bis 120 Sekunden betragen. Dabei werden die Silizium-Wafer vorteilhaft kontinuierlich bewegt bzw. durch ein entsprechendes Texturierungs-Modul gefahren auf der Transportbahn.

Im ersten Verfahrensschritt wird auf der Unterseite etwa 2µm an Material abgetragen bzw. weggeätzt. Damit ist auch hier ein Teil der Sägeschäden bereits beseitigt, während eine hier ungewünschte Texturierung der Oberfläche noch nicht richtig stattgefunden hat. Nach dem Verfahrensschritt des Texturierens kann ein Spülen der Silizium-Wafer erfolgen, vorteilhaft mit Wasser.

Als Ätzlösung für den ersten Verfahrensschritt kann eine übliche Ätzlösung zum Texturieren verwendet werden, vorzugsweise mit einer Mischung aus HF und HNO₃. Im ersten Verfahrensschritt bzw. bei dessen Durchführung im Texturierungs-Modul kann das Aufbringen von Ätzlösung zum Texturieren in mehreren Bereichen hintereinander entlang der Transportbahn erfolgen. Dazu sind vorteilhaft hintereinander mehrere Gruppen von Düsen odgl. zum Aufsprühen der Ätzlösung vorgesehen, vorteilhaft an quer zur Transportbahn verlaufenden Schwallrohren odgl.. Auch dies ist grundsätzlich bekannt.

Das Texturierungs-Modul ist vorteilhaft mit einer Auffangwanne unter der Transportbahn versehen, so dass ablaufende Ätzlösung aufgefangen und weiterverwendet werden kann. Das genannte Spülen der Silizium-Wafer nach dem Benetzen mit Ätzlösung im ersten Verfahrensschritt im Texturierungs-Modul erfolgt vorteilhaft ebenfalls in diesem Texturierungs-Modul, besonders vorteilhaft an seinem Ende. Ein Abschnitt des Texturierungs-Moduls kann zum Spülen mit Wasser ausgebildet sein, wobei hier eine Auffangwanne getrennt von der Auffangwanne für Ätzlösung vorgesehen ist zur Trennung der beiden Flüssigkeiten, damit weniger Reinigungsaufwand entsteht. Die Intensität der Spülung mit Wasser an den Silizium-Wafern, also die Wassermenge, kann erheblich über derjenigen für das Benetzen mit Ätzlösung liegen.

Vorteilhaft fahren die Silizium-Wafer nach dem ersten Verfahrensschritt bzw. aus dem Texturierungs-Modul direkt zum nächsten bzw. zweiten Verfahrensschritt, welcher in einem Polierätz-Modul stattfindet. Hier wird Ätzlösung zum Polierätzen aufgebracht, wobei die Silizium-Wafer jedenfalls kontinuierlich auf einer Transportbahn durch das Polierätz-Modul transportiert werden. Eine Benetzung der Silizium-Wafer erfolgt ausschließlich an ihrer Unterseite. Dies kann einerseits durch leichtes Sprühen von unten erfolgen. Vorteilhaft werden hierzu ein Verfahren sowie eine Vorrichtung in dem Polierätz-Modul gemäß der DE 10 2005 062 528 A1, auf die explizit verwiesen wird, verwendet. Dabei sind Transportrollen für die Silizium-Wafer zum Großteil in ein Bad mit der Ätzlösung zum Polierätzen eingetaucht. Beim Drehen bleibt an ihrer Oberseite Ätzlösung haften, welche dann an die Unterseiten der Silizium-Wafer gebracht wird und dort das Polierätzen übernimmt. So kann ein Ätzabtrag von 3µm bis 10µm an der Unterseite erreicht werden, wodurch eben ein sehr gutes Polierätzen möglich ist mit sehr gutem Ergebnis hinsichtlich einer glatten und glänzenden Rückseite. Dieser Verfahrensschritt kann hier etwas länger dauern als beim vorhergehenden Verfahrensschritt, insbesondere kann bei etwa 200 Sekunden liegen. Durch die Verfahrensdauer kann auch hier der Ätzabtrag bestimmt werden. Als Ätzlösung wird zum Polierätzen eine ähnliche verwendet wie beim Texturieren, allerdings mit einem größeren HNO₃-Anteil. Die Ätzvorgänge können bei Raumtemperatur durchgeführt werden, wobei sich ein Temperaturbereich von ca. 4°C bis ca. 40°C erstreckt.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombination bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ein Ausführungsbeispiel der Erfindung ist in den Zeichnungen schematisch dargestellt und wird im Folgenden näher erläutert. In den Zeichnungen zeigen:
- Fig. 1: eine schematische Darstellung einer Vorrichtung zum Texturie- ren durch Besprühen von Silizium-Wafern von oben und
- Fig. 2: eine schematische Darstellung einer weiteren Vorrichtung zum Polierätzen von Silizium-Wafern durch Benetzen mittels Trans- portrollen von unten.

### Detaillierte Beschreibung des Ausführungsbeispiels

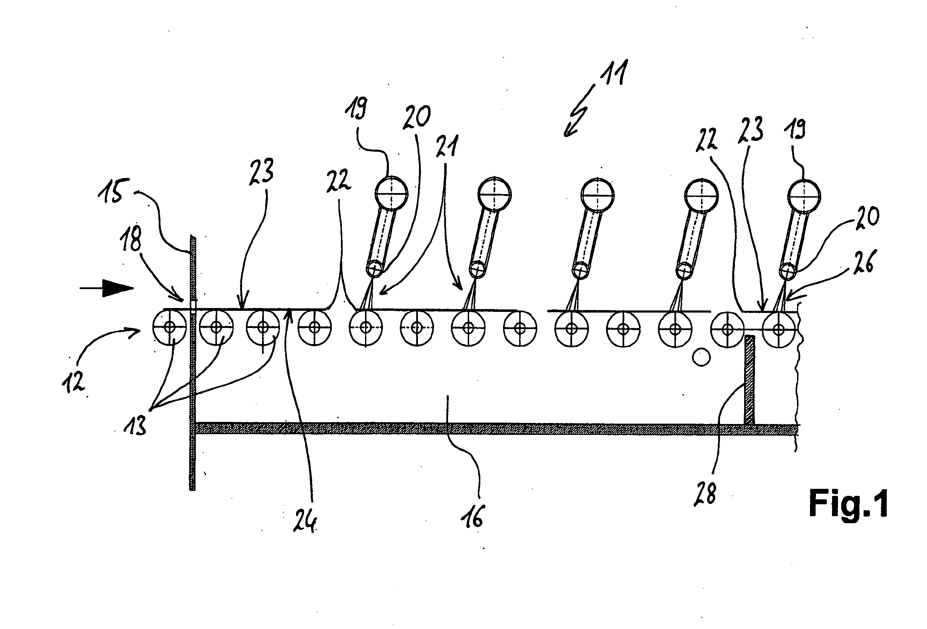

In Fig. 1 ist ein Texturierungs-Modul 11 dargestellt mit einer Transportbahn 12, die auf übliche Art und Weise von mehreren Transportrollen 13 gebildet wird. Das Texturierungs-Modul 11 weist ein Gehäuse 15 auf, welches eine Auffangwanne 16 enthält sowie von links einen Einlauf 18 an der Transportbahn 12.

Oberhalb der Auffangwanne 16 sowie der Transportbahn 12 sind mehrere Schwallrohre 19 parallel zueinander vorgesehen, die quer zu der Transportbahn 12 verlaufen können. Sie weisen nach unten gerichtete Düsen 20 auf, welche Ätzlösung 21 ausbringen. Auch diese Düsen 20 sind dem Fachmann an sich bekannt. Sie können starr ausgerichtet sein oder aber beweglich. Des weiteren können die Düsen 20 auch unter Umständen einzeln oder in Gruppen aktivierbar sein, um ein bestimmtes Profil des Austrags der Ätzlösung 21 zu erreichen.

Silizium-Wafer 22 werden auf den Transportrollen 13 liegend entlang der Transportbahn 12 transportiert. Die Oberseiten 23 bilden später die Vorderseiten von Solarzellen, und die Unterseiten 24, die auf den Transportrollen 13 aufliegen, bilden deren Rückseiten.

Wie aus Fig. 1 zu erkennen ist, erfolgt ein Auftrag von Ätzlösung 21 nur an die Oberseiten 23 der Silizium-Wafer 22. Somit erfolgt hier hauptsächlich im ersten Verfahrensschritt das Texturieren der Silizium-Wafer 22 bzw. ihrer Oberseiten 23. Dabei ist es selbstverständlich klar, dass eine gewissen Menge an Ätzlösung 21 insbesondere über die Vorderkanten und Rückkanten der Silizium-Wafer 22, überläuft und sich dann auf den Transportrollen 13 befindet. Nachfolgende, auf den Transportrollen 13 liegende Silizium-Wafer 22 werden dann auch an ihrer Unterseite 24 mit dieser Ätzlösung 21 benetzt. Allerdings ist hier die Menge an Ätzlösung 21 erheblich geringer, so dass auch ein erheblich geringeres Ätzen erfolgt. Da aber, wie dargestellt ist, das gezielte Aufbringen der Ätzlösung 21 von oben mittels der Düsen 20 erfolgt, spricht man hier von einem Aufbringen von Ätzlösung von oben im Sinne der Erfindung.

Es kann eingestellt werden, ob die Düsen 20 beispielsweise oberhalb der Transportrollen 13 angeordnet sind oder auf diese zu ausgerichtet sind, so dass Ätzlösung 21 auf die Transportrollen 13 gebracht wird, wenn gerade kein Silizium-Wafer 22 darunter ist, was das Benetzen der Unterseiten 24 des nächsten Silizium-Wafers 22 mit Ätzlösung 21 verstärkt. Werden die Düsen 20 anders angeordnet oder ausgerichtet, ist dieser Effekt erheblich schwächer. Des weiteren kann auch durch gezieltes Ansteuern der Düsen 20 bzw. durch einen gezielten Austrag der Ätzlösung 21 auf die Oberseiten 23 der Silizium-Wafer 22 dieser Effekt des Ätzens an der Unterseite beeinflusst werden.

In dem nach rechts weitergeführten Texturierungs-Modul 11 kann die ganz rechts dargestellte Düse 20 dazu ausgebildet sein, keine Ätzlösung 21 auszubringen, sondern Wasser bzw. Spülwasser 26. Dadurch kann der Silizium-Wafer 22 in diesem Bereich bzw. seine Oberseite 23 von Ätzlösung 21 gereinigt werden. In der Auffangwanne 16 ist dazu die Abtrennung 28 vorgesehen, so dass sich links davon abgetropfte Ätzlösung 21 befindet und rechts davon das zu einem geringen Teil mit Ätzlösung versetzte Spülwasser 26. Die Anzahl der hintereinander folgenden Schwallrohre 19 mit Düsen 20 zum Aufbringen von Ätzlösung 21 kann variieren und entsprechend der gewünschten Transportgeschwindigkeit sowie Verfahrensdauer variiert werden. Ebenso können vorteilhaft mehrere Düsen 20 für Spülwasser 26 zum Spülen der Silizium-Wafer 22 vorgesehen werden.

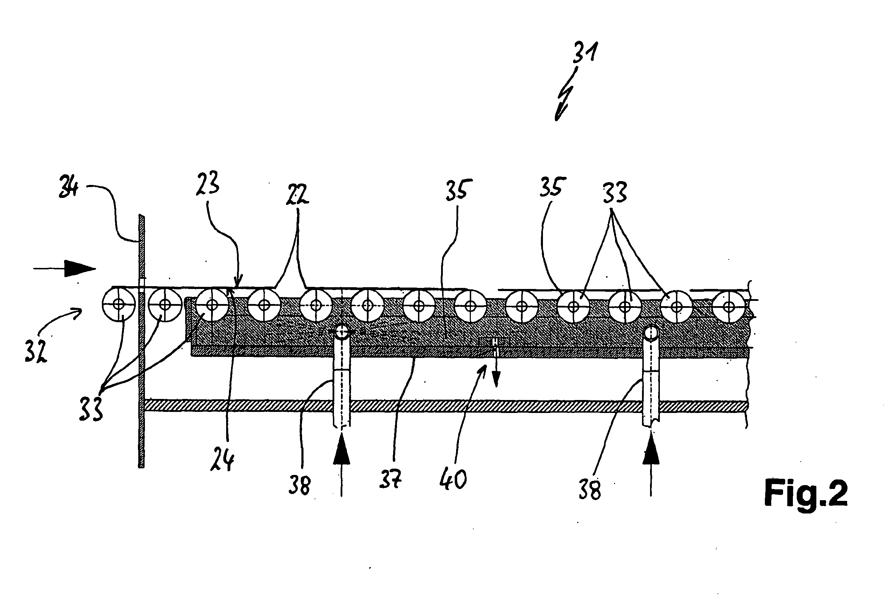

In Fig. 2 ist ein Polierätz-Modul 31 dargestellt. Auch dieses weist eine Transportbahn 32 auf, welche die Fortführung der Transportbahn 12 von Fig. 1 ist. Ebenso ist vorteilhaft das Polierätz-Modul 31 relativ direkt aufeinander folgend zu dem Texturierungs-Modul 11 vorgesehen und aufgestellt. Die Transportbahn 32 wird durch Transportrollen 33 gebildet. Für eine Detailbeschreibung des Polierätz-Moduls 31 wird vor allem auf die DE 10 2005 062 528 A1 verwiesen, in der detailliert beschrieben wird, wie die Ätzlösung 35 zum Polierätzen aus dem Bad 37 mittels der Transportrollen 33 an die Unterseiten 24 der Silizium-Wafer 22 gebracht wird. Sie dienen also zum Transport der Wafer und zum Benetzen ihrer Unterseiten. Die Ätzlösung 35 zum Polierätzen ist wie vorbeschrieben. Es ist aus der Darstellung in Fig. 2 auch zu erkennen, dass in dem zweiten Verfahrensschritt keinerlei Ätzlösung 35 auf die Oberseite 23 der Silizium-Wafer 22 gelangen kann, sondern nur an die Unterseiten 24. Das Bad 37 weist zwischen zwei Zuführrohren 38, die neue Ätzlösung 35 in das Bad 37 einbringen, einen Ablauf 40 auf. Dieser stellt zusätzlich zu dem seitlichen Überlauf über den Rand des Bades 37 einen Austausch von Ätzlösung 35 sicher derart, dass nicht nur im Bereich des Austritts der Zuführrohre 38 frische Ätzlösung 35 ist, sondern diese auch in Richtung des Ablaufs 40 hin bewegt wird und somit auch dort von den Transportrollen 33 an die Unterseite 24 der Silizium-Wafer 22 gebracht werden kann. Im Verfahrensablauf der Behandlung der Silizium-Wafer 22 erfolgt auch nach dem Polierätzen in dem Polierätz-Modul 31 ein weiteres Spülen, vorteilhaft wiederum mit Wasser.

Auch das Polierätz-Modul 31 ist in einem Gehäuse 34 vorgesehen. Eine Absaugung von Dämpfen der Ätzlösungen kann bei beiden Modulen selbstverständlich vorgesehen sein.

Die Substrate sind typischerweise flache, ebene Silizium-Wafer 22, die eine runde Kontur mit einem Durchmesser von ungefähr 60mm bis 250mm oder eine rechteckige Kontur mit Kantenlängen von 60mm bis 250mm aufweisen. Eine bevorzugte Dicke liegt im Bereich von 0,1 mm bis 2mm.

## Patentansprüche

1. Verfahren zur Behandlung von Silizium-Wafern (22), **dadurch gekennzeichnet, dass** in einem ersten Verfahrensschritt die Silizium-Wafer (22) liegend entlang einer horizontalen Transportbahn (12, 32) transportiert werden und von oben Ätzlösung (21) zum Texturieren aufgebracht bzw. aufgesprüht wird durch Düsen (20) odgl., während von unterhalb der Silizium-Wafer (22) in diesem ersten Verfahrensschritt kein oder nur ein geringes Aufbringen von Ätzlösung (21) auf die Silizium-Wafer (22) erfolgt, wobei in einem zweiten Verfahrensschritt die Silizium-Wafer (22) mit gleicher Ausrichtung wie im ersten Verfahrensschritt von unten mit Ätzlösung (35) zum Polierätzen benetzt werden, vorzugsweise ausschließlich von unten.

2. Verfahren nach Anspruch 1, **dadurch gekennzeichnet, dass** zwischen dem ersten Verfahrensschritt des Texturierens und dem zweiten Verfahrensschritt des Polierätzens ein Spülen erfolgt, insbesondere ein Spülen mit Wasser (26).

3. Verfahren nach Anspruch 1 oder 2, **dadurch gekennzeichnet, dass** im ersten Verfahrensschritt Ätzlösung (21) über Transportrollen (13), auf denen die Silizium-Wafer (22) transportiert werden, an die Unterseite (24) der Silizium-Wafer gebracht wird, wobei vorzugsweise diese an die Unterseite (24) gebrachte Menge an Ätzlösung (21) erheblich geringer ist als die an die Oberseite (23) gebrachte Menge an Ätzlösung (21).

4. Verfahren nach einem der vorhergehenden Ansprüche, **dadurch gekennzeichnet, dass** im ersten Verfahrensschritt zum Texturieren an der Oberseite (23) etwa 4 µm bis 6 µm Material abgetragen werden, vorzugsweise ca. 5 µm, und an der Unterseite (24) 1 µm bis 3 µm abgetragen werden, vorzugsweise ca. 2 µm, wobei insbesondere von der Oberseite (23) etwas mehr als doppelt so viel abgetragen wird wie von der Unterseite (24).

5. Verfahren nach einem der vorhergehend Ansprüche, **dadurch gekennzeichnet, dass** der erste Verfahrensschritt ca. 80 Sekunden bis 120 Sekunden dauert, wobei vorzugsweise die Silizium-Wafer (22) kontinuierlich weiter transportiert werden.

6. Verfahren nach einem der vorhergehenden Ansprüche, **dadurch gekennzeichnet, dass** im ersten Verfahrensschritt das Aufbringen der Ätzlösung (21) zum Texturieren in mehreren Bereichen hintereinander entlang der Transportbahn (12) der Silizium-Wafer (22) erfolgt, vorzugsweise durch mehrere, quer zur Transportbahn (12) verlaufende Schwallrohre (19) samt Düsen (20).

7. Verfahren nach einem der vorhergehenden Ansprüche, **dadurch gekennzeichnet, dass** im zweiten Verfahrensschritt das Aufbringen von Ätzlösung (35) zum Polierätzen im kontinuierlichen Durchlauf der Silizium-Wafer (22) erfolgt, wobei vorzugsweise die Benetzung mit Ätzlösung (35) zum Polierätzen über Transportrollen (33) für die Silizium-Wafer (22) erfolgt, die zum Großteil in ein Bad mit Ätzlösung (35) eingetaucht sind und an ihrer Oberfläche die Ätzlösung (35) an die Unterseite (24) der Silizium-Wafer (22) bringen.

8. Verfahren nach Anspruch 7, **dadurch gekennzeichnet, dass** die Dauer des zweiten Verfahrensschrittes zum Polierätzen bei etwa 200 Sekunden liegt.

9. Verfahren nach Anspruch 7 oder 8, **dadurch gekennzeichnet, dass** als
Ätzlösung (35) zum Polierätzen eine ähnliche Ätzlösung verwendet wird wie zum Texturieren, vorzugsweise mit einer Mischung aus HF und HNO₃, wobei insbesondere bei der Ätzlösung (35) zum Polierätzen der HNO₃-Anteil größer ist.

## Claims

1. A method for treating silicon wafers (22), **characterized in that**, in a first method step, the silicon wafers (22) are transported in a horizontal position along a horizontal transport path (12, 32) and etching solution (21) for texturing is applied or sprayed on from above by means of nozzles (20) or the like, while no or only little etching solution (21) is applied to the silicon wafers (22) from below the silicon wafers (22) in this first method step, wherein, in a second method step, the silicon wafers (22), with the same orientation as in the first method step, are wetted with etching solution (35) for polish-etching from below, preferably exclusively from below.

2. The method as claimed in claim 1, **characterized in that** rinsing, in particular rinsing with water (26), is effected between the first method step of texturing and the second method step of polish-etching.

3. The method as claimed in claim 1 or 2, **characterized in that**, in the first method step, etching solution (21) is brought to the underside (24) of the silicon wafers by means of transport rollers (13) on which the silicon wafers (22) are transported, wherein this amount of etching solution (21) brought to the underside (24) is preferably considerably smaller than the amount of etching solution (21) brought to the top side (23).

4. The method as claimed in any of preceding claims, **characterized in that**, in the first method step for texturing, approximately 4 µm to 6 µm of material, preferably approximately 5 µm, are removed at the top side (23) and 1 µm to 3 µm, preferably approximately 2 µm, are removed at the underside (24), wherein, in particular, the amount removed from the top side (23) is somewhat more than double the amount removed from the underside (24).

5. The method as claimed in any of preceding claims, **characterized in that** the first method step lasts for approximately 80 seconds to 120 seconds, wherein the silicon wafers (22) are preferably transported further in a continuous fashion.

6. The method as claimed in any of preceding claims, **characterized in that**, in the first method step, the etching solution (21) for texturing is applied in a plurality of regions successively along the transport path (12) of the silicon wafers (22), preferably by means of a plurality of surge pipes (19) together with nozzles (20) running transversely with respect to the transport path (12).

7. The method as claimed in any of preceding claims, **characterized in that**, in the second method step, etching solution (35) for polish-etching is applied with continuous passage of the silicon wafers (22), wherein the wetting with etching solution (35) for polish-etching is preferably effected by means of transport rollers (33) for the silicon wafers (22), which for the most part are immersed in a bath containing etching solution (35) and at their surface bringing the etching solution (35) to the underside (24) of the silicon wafers (22).

8. The method as claimed in claim 7, **characterized in that** the duration of the second method step for polish-etching is approximately 200 seconds.

9. The method as claimed in claim 7 or 8, **characterized in that** the etching solution (35) used for polish-etching is an etching solution similar to that used for texturing, preferably comprising a mixture of HF and HNO₃, wherein the HNO₃ proportion is greater particularly in the case of the etching solution (35) for polish-etching.

## Revendications

1. Procédé de traitement de tranches ou *wafers* en silicium (22), **caractérisé en ce que** dans une première étape de procédé les wafers en silicium (22) sont transportés de manière allongée le long d'une voie de transport horizontale (12, 32) et que une solution d'attaque (21) est appliquée ou encore aspergée en fines gouttelettes d'en haut sur celui-ci par des buses (20) ou similaires pour obtenir une texturation (*Texturieren*), tandis que dans cette première étape de procédé une application d'une solution d'attaque (21) d'en bas sur le *wafer* de silicium (22) n'a pas lieu ou n'a lieu que de manière limitée, sachant que dans une deuxième étape de procédé les *wafers* en silicium (22) sont mouillés d'en bas par la solution d'attaque (35) en étant orientés de la même manière que pendant la première étape de procédé pour une morsure de polissage *(Polierätzen),* de préférence uniquement d'en bas.

2. Procédé d'après la revendication 1, **caractérisé en ce que** entre la première étape de procédé de texturation et la deuxième étape de procédé de morsure de polissage a lieu un rinçage, notamment un rinçage à l'eau (26).

3. Procédé d'après la revendication 1 ou 2, **caractérisé en ce que** dans la première étape de procédé de la solution d'attaque (21) est amenée à la face inférieure (24) des *wafers* en silicium par des rouleaux de transport (13), sur lesquels les *wafers* en silicium (22) sont transportés, sachant que de préférence cette quantité de solution d'attaque (21) amenée à la face inférieure (24) est nettement inférieure à la quantité de solution d'attaque (21) amenée à la face supérieure (23).

4. Procédé d'après une des revendications précédentes, **caractérisé en ce que** dans la première étape de procédé pour la texturation l'enlèvement de matériau à la face supérieure (23) comporte à peu près de 4 µm à 6 µm, de préférence à peu près 5 µm, et que à la face inférieure (24) on enlève de 1 µm à 3 µm, de préférence à peu près 2 µm, sachant que notamment à la face supérieure (23) on enlève un peu plus que le double qu'à la face inférieure (24).

5. Procédé d'après une des revendications précédentes, **caractérisé en ce que** la première étape de procédé dure à peu près de 80 secondes à 120 secondes, sachant que de préférence on fait avancer les *wafers* en silicium (22) de manière continue.

6. Procédé d'après une des revendications précédentes, **caractérisé en ce que** dans la première étape de procédé l'application de la solution d'attaque (21) pour la texturation a lieu à plusieurs endroits l'un derrière l'autre le long de la voie de transport (12) des *wafers* en silicium (22), de préférence par plusieurs tuyaux de flot (*Schwallrohre*) (19), s'étendant transversalement par rapport à la voie de transport (12), avec des buses (20).

7. Procédé d'après une des revendications précédentes, **caractérisé en ce que** dans la deuxième étape de procédé l'application de la solution d'attaque (35) pour la morsure de polissage a lieu par un passage continu des *wafers* en silicium (22), sachant que de préférence le mouillage par la solution d'attaque (35) pour la morsure de polissage a lieu par des rouleaux de transport (33) pour les *wafers* en silicium (22), rouleaux qui sont noyés en grande partie dans un bain de solution d'attaque (35) et qui amènent la solution d'attaque (35) par leur surface à la face inférieure (24) des *wafers* en silicium (22).

8. Procédé d'après la revendication 7, **caractérisé en ce que** la durée de la deuxième étape de procédé pour la morsure de polissage comporte à peu près 200 secondes.

9. Procédé d'après la revendication 7 ou 8, **caractérisé en ce que** en tant que solution d'attaque (35) pour la morsure de polissage est employée une solution d'attaque similaire à celle qui est utilisée pour la texturation, de préférence avec un mélange de HF et de HNO₃, sachant que notamment dans la solution d'attaque (35) pour la morsure de polissage le pourcentage de HNO₃ est plus grand.
